# EUROPEAN PATENT APPLICATION

(11) **EP 4 742 842 A1**
(43) Date of publication of application: **13.05.2026**
(21) Application number: 24835873.1
(22) Date of filing: 13.06.2024
(51) Int. Cl.: H05K 3/42, H05K 1/02, H05K 1/11

(54) **METHOD FOR MANUFACTURING FLEXIBLE PRINTED WIRING BOARD, AND FLEXIBLE PRINTED WIRING BOARD**

(30) Priority: 03.07.2023 JP 2023109563
(71) Applicant: Fujikura Printed Circuits Ltd., Tokyo, 135-0042 (JP)
(72) Inventor: OGAWA, Akiko, Tokyo 135-8512 (JP); OKADA, Jun, Tokyo 135-8512 (JP)
(74) Representative: Ter Meer Steinmeister & Partner
(86) International application number: PCT/JP2024/021580
(87) International publication number: WO 2025/009357

(57) **Abstract**

A method of manufacturing a flexible printed wiring board 1A includes a preparing step of preparing a double-sided substrate 100 having an insulating base material 10 and metal foil layers 102a, 102b laminated on an insulating layer, a hole formation step of forming a through hole 50 in the insulating base material 10 and the metal foil layers 102a, 102b, and a plating step of forming first and second plating layers 103 around and inside the through hole. The plating step includes a first plating step of forming the first plating layer 103 around and inside the through hole by a panel plating method, and a second plating step of forming a second plating layer 104 around and inside the through hole by a pattern plating method.

## Description

### Technical Field

The present invention relates to a method of manufacturing a flexible printed wiring board as well as a flexible printed wiring board.

In designated states where incorporation of documents by reference is accepted, the contents described in Japanese Patent Application No. 2023-109563 filed on July 3, 2023 in Japan are incorporated by reference into this specification and are regarded as a portion of the description of this specification.

### Background Art

An increase in the total thickness of electrode layers that form a wiring circuit is disadvantageous for forming fine wiring (see, for example, paragraph [0004] of Patent Document 1). In contrast to this, it has been known to manufacture a printed wiring board using a button plating method in which plating is applied thickly only to an interlayer connection portion to ensure connection reliability (see, for example, paragraphs [0006] to [0016] and FIG. 5 of Patent Document 1).

In the button plating method, the printed wiring board is usually manufactured by the following steps. First, a double-sided copper clad laminate having copper foils on both sides of an insulating base material is prepared (see, for example, FIG. 5(1) of Patent Document 1). Next, a through hole is formed in the double-sided copper clad laminate, and subsequently, desmear treatment and conductive treatment are performed as pretreatment for achieving interlayer connection by electrolytic plating (see, for example, FIG. 5(2) of Patent Document 1).

Next, a photosensitive dry film to be used as a plating resist is laminated, followed by exposure and development, whereby an opening of the photosensitive dry film is formed at and around the through hole. Next, a copper plating layer is formed over the through hole of the double-sided copper clad laminate and the opening of the photosensitive dry film using an electrolytic copper plating process to achieve electrical interlayer connection. Subsequently, by peeling off the photosensitive dry film, the double-sided copper clad laminate in which plating is applied thickly only to the interlayer connection portion is obtained (see, for example, FIG. 5(3) of Patent Document 1).

Next, photosensitive dry films to be used as etching resists are laminated on both sides of the double-sided copper clad laminate, followed by exposure and development (see, for example, FIG. 5(4) of Patent Document 1). Next, a wiring circuit is formed on the copper foil using etching by a subtractive method, and the photosensitive dry film is peeled off (see, for example, FIG. 5(5) of Patent Document 1). Through the above steps, a double-sided printed wiring board in which plating is applied thickly only to the interlayer connection portion is obtained.

### Prior Art Document

### Patent Document

Patent Document 1: JP 2009-88334 A

### Summary of Invention

### Problems to Be Solved by Invention

In the above conventional technique using the button plating method, a level difference formed between the copper foil as a base and the plating applied thickly only to the interlayer connection portion becomes large. Accordingly, when the photosensitive dry film to be used as the etching resist is laminated on the double-sided copper clad laminate, the photosensitive dry film may tear due to the level difference, causing poor formation in the wiring circuit. On the other hand, when the plating formed by the button plating method is thinned to make the level difference small, the interlayer connection portion becomes thinner, leading to a possibility of a reduction in electrical connection reliability.

A problem to be solved by the present invention is to provide a method of manufacturing a flexible printed wiring board as well as a flexible printed wiring board that is capable of suppressing poor formation of a wiring pattern and improving connection reliability.

### Means for Solving Problems

[1] An aspect 1 of the present invention is a method of manufacturing a flexible printed wiring board, the method including a preparing step of preparing a substrate having an insulating layer and a metal foil layer laminated on the insulating layer, a hole formation step of forming a hole in the insulating layer and the metal foil layer, and a plating step of forming a plating layer around and inside the hole, the plating step including a first plating step of forming a first plating layer around and inside the hole by a panel plating method, and a second plating step of forming a second plating layer around and inside the hole by a pattern plating method.
[2] An aspect 2 of the present invention may be the method of manufacturing the flexible printed wiring board according to the aspect 1, in which the first plating step may include forming the first plating layer such that the first plating layer has a thickness of 1/2 or less of a thickness of the metal foil layer, and the second plating step may include forming the second plating layer such that the second plating layer has a thickness of 1/2 or less of the thickness of the metal foil layer.
[3] An aspect 3 of the present invention may be the method of manufacturing the flexible printed wiring board according to the aspect 1 or 2, in which the second plating step may be performed after the first plating step and include forming the second plating layer on the first plating layer.
[4] An aspect 4 of the present invention may be the method of manufacturing the flexible printed wiring board according to the aspect 1 or 2, in which the first plating step may be performed after the second plating step and include forming the first plating layer on the second plating layer.
[5] An aspect 5 of the present invention may be the method of manufacturing the flexible printed wiring board according to any one of the aspects 1 to 4, the method further including a patterning step of etching the second plating layer, the first plating layer, and the metal foil layer to form a wiring pattern and a land portion surrounding the hole, in the land portion, a diameter of the second plating layer being smaller than a diameter of the first plating layer.
[6] An aspect 6 of the present invention is a flexible printed wiring board including an insulating layer and a land portion laminated on the insulating layer, in which the land portion includes a metal foil layer, a third plating layer laminated on the metal foil layer, and a fourth plating layer laminated on the third plating layer, the flexible printed wiring board has a hole formed in the insulating layer and the metal foil layer and surrounded by the land portion, the third and fourth plating layers are formed around and inside the hole, and in the land portion, a diameter of the third plating layer is different from a diameter of the fourth plating layer.
[7] An aspect 7 of the present invention may be the flexible printed wiring board according to the sixth aspect, in which a thickness of the third plating layer is 1/2 or less than a thickness of the metal foil layer, and a thickness of the fourth plating layer is 1/2 or less than the thickness of the metal foil layer.

### Effects of Invention

In the method of manufacturing the flexible printed wiring board according to the present invention, the plating step includes the first plating step of forming the first plating layer by the panel plating method around and inside the hole formed in the insulating layer and the metal foil layer, and the second plating step of forming the second plating layer around and inside the hole by the pattern plating method. This can gradually make the plating layer around the hole thinner toward the outside of the hole, thereby reducing the level difference as described above. At the same time, the plating layer having a sufficient thickness can be formed around and inside the hole. As described above, it is possible to suppress poor formation of the wiring pattern and improve connection reliability.

The flexible printed wiring board according to the present invention includes the land portion including the third plating layer and the fourth plating layer having diameters different from each other. With such a configuration, the flexible printed wiring board can be manufactured by the manufacturing method described above, and thus, it is possible to suppress poor formation of the wiring pattern and improve connection reliability.

### Brief Description of Drawings

FIG. 1 is a sectional view showing a flexible printed wiring board according to a first embodiment of the present invention.
FIG. 2(a) is an enlarged plan view of part II in FIG. 1, and FIG. 2(b) is an enlarged sectional view of part II in FIG. 1.
FIG. 3(a) to FIG. 3(k) are each a sectional view showing a method of manufacturing the flexible printed wiring board according to the first embodiment of the present invention.
FIG. 4 is a sectional view showing a flexible printed wiring board according to a second embodiment of the present invention.
FIG. 5(a) to FIG. 5(k) are each a sectional view showing a method of manufacturing the flexible printed wiring board according to the second embodiment of the present invention.
FIG. 6(a) is a sectional view showing a modification of an interlayer connection portion of the flexible printed wiring board according to the first embodiment, and FIG. 6(b) is a sectional view showing a modification of an interlayer connection portion of the flexible printed wiring board according to the second embodiment.

### Mode(s) for Carrying out the Invention

### [First Embodiment]

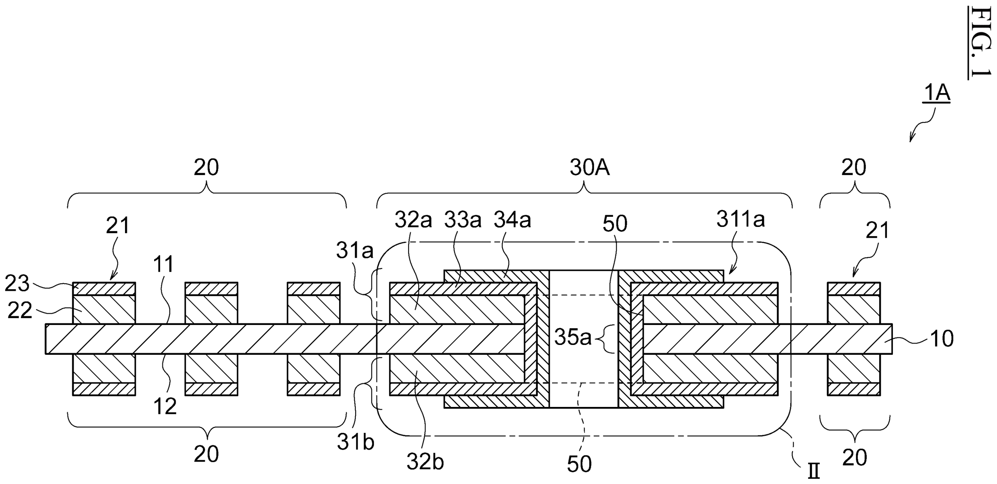

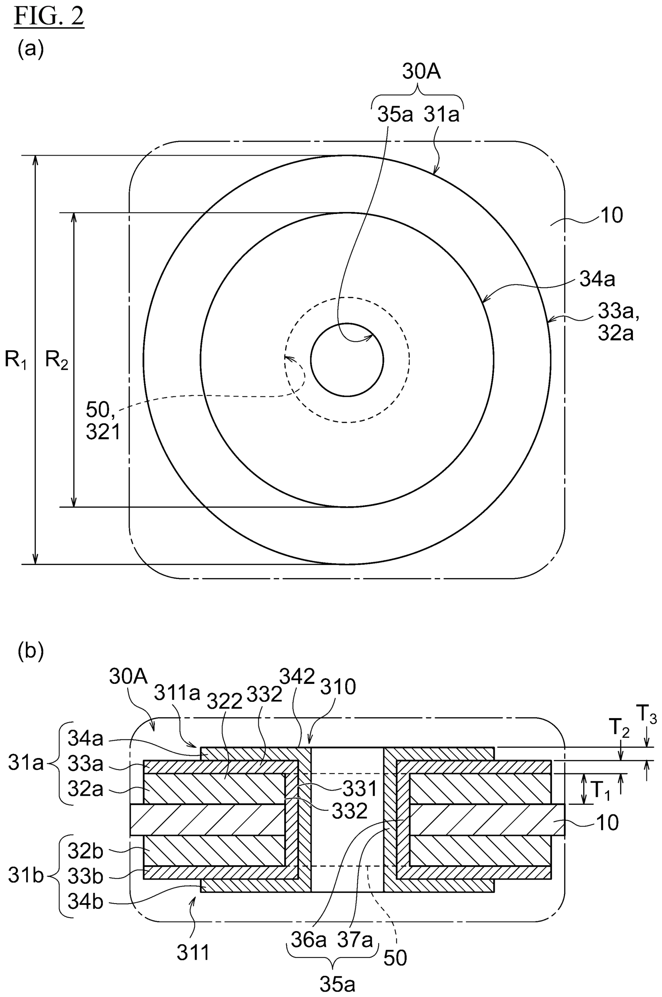

The following describes embodiments of the present invention with reference to the drawings. FIG. 1 is a sectional view showing a flexible printed wiring board 1A according to a first embodiment. FIG. 2(a) is an enlarged plan view of part II in FIG. 1. FIG. 2(b) is an enlarged sectional view of part II in FIG. 1.

As shown in FIG. 1, the flexible printed wiring board 1A according to the present embodiment is a double-sided flexible printed wiring board (FPC) having wiring patterns 20 on both sides. The flexible printed wiring board 1A includes an insulating base material 10, the wiring pattern 20, an interlayer connection portion 30A, and a through hole 50. The insulating base material 10 corresponds to an example of the "insulating layer" in the aspects of the present invention, and the through hole 50 corresponds to an example of the "hole" in the aspects of the present invention.

The insulating base material 10 is a flexible resin film. The insulating base material 10 is made of a material having electrical insulating properties, such as a resin material. Although not particularly limited, examples of the material constituting the insulating base material 10 may include polyimide (PI), liquid crystal polymer (LCP), polyethylene terephthalate (PET), polyethylene naphthalate (PEN), polyetherimide (PEI), polyetheretherketone (PEEK), and aramid. Although not particularly limited, the insulating base material 10 in the present embodiment is an insulating film of a flexible copper clad laminate (FCCL).

The wiring patterns 20 are formed on a top surface 11 and a bottom surface 12 of the insulating base material 10. The wiring pattern 20 in the present embodiment includes a linear fine lines 21 having conductivity. Note that the wiring pattern 20 may include a pad, a terminal, and the like in addition to the fine lines 21.

The fine line 21 in the present embodiment includes a first metal foil layer 22 and a first panel plating layer 23. The first metal foil layer 22 is formed on each of the top surface 11 and the bottom surface 12 of the insulating base material 10. Although not particularly limited, examples of the material constituting the first metal foil layer 22 may include copper, silver, and gold. Although not particularly limited, the first metal foil layer 22 in the present embodiment is a copper foil.

The first panel plating layer 23 is formed on the first metal foil layer 22 by an electrolytic panel plating method. Although not particularly limited, examples of the material constituting the first panel plating layer 23 may include copper, silver, and gold. Although not particularly limited, the first panel plating layer 23 in the present embodiment is a copper plating layer formed by a panel plating method. Note that the material constituting the first panel plating layer 23 may be the same material as that of the first metal foil layer 22, or may be a material different from that of the first metal foil layer 22.

The interlayer connection portion 30A is formed from the top surface 11 to the bottom surface 12 of the insulating base material 10 via the through hole 50. Note that the through hole 50 is a cylindrical hole that penetrates the insulating base material 10 and second metal foil layers 32a, 32b (described below) constituting land portions 31a, 31b (described below) respectively.

The interlayer connection portion 30A penetrates the insulating base material 10 at the through hole 50, and the second metal foil layers 32a, 32b in the interlayer connection portion 30A are electrically connected to each other. Note that the interlayer connection portion 30A may or may not be connected to the wiring pattern 20.

As shown in FIGS. 1, 2(a), and 2(b), the interlayer connection portion 30A includes the land portions 31a, 31b and a through-hole plating portion 35a. The land portion 31a has an annular shape concentric with the through hole 50, and is formed on the top surface 11 so as to surround the through hole 50. More precisely, part of the inside of the land portion 31a is located inside the through hole 50 and also above the through hole 50.

The land portion 31a includes the second metal foil layer 32a, a second panel plating layer 33a, and a first pattern plating layer 34a. The second metal foil layer 32a corresponds to an example of the "metal foil layer" of the flexible printed wiring board in the aspects of the present invention, the second panel plating layer 33a corresponds to an example of the "third plating layer" in the aspects of the present invention, and the first pattern plating layer 34a corresponds to an example of the "fourth plating layer" in the aspects of the present invention.

The second metal foil layer 32a is formed on the top surface 11 of the insulating base material 10. As shown in FIG. 2(a), the second metal foil layer 32a has an annular shape surrounding the through hole 50, and an inner peripheral surface 321 of the second metal foil layer 32a defines an upper part of the through hole 50. Although not particularly limited, examples of the material constituting the second metal foil layer 32a may include copper, silver, and gold. Although not particularly limited, the second metal foil layer 32a in the present embodiment is a copper foil.

As shown in FIG. 2(b), the second panel plating layer 33a is formed on the inner peripheral surface 321 and a top surface 322 of the second metal foil layer 32a. The second panel plating layer 33a in the present embodiment covers the whole of the inner peripheral surface 321 and the top surface 322 of the second metal foil layer 32a, and has an annular shape following the shape of the second metal foil layer 32a.

The second panel plating layer 33 is formed on the second metal foil layer 32a by the electrolytic panel plating method. Although not particularly limited, examples of the material constituting the second panel plating layer 33a may include the same material as the first panel plating layer 23. However, the material constituting the second panel plating layer 33a may be a material different from that of the first panel plating layer 23.

Although not particularly limited in the present embodiment, a thickness T₂ of the second panel plating layer 33a is 1/2 or less of a thickness T₁ of the second metal foil layer 32a (T₂ ≤ (1/2) × T₁). Although not particularly limited, the thickness T₂ of the second panel plating layer 33a may be 1/5 or more of the thickness T₁ of the second metal foil layer 32a (T₂ ≥ (1/5) × T₁). The thickness T₂ of the second panel plating layer 33a is 1/2 or less of the thickness T₁ of the second metal foil layer 32a, whereby the fine lines of the wiring pattern 20 can be formed with high accuracy.

Although not particularly limited, the thickness T₂ of the second panel plating layer 33a may be, for example, in the range of 2 µm to 5 µm (2 µm ≤ T₂ ≤ 5 µm), and the thickness T₁ of the second metal foil layer 32a may be, for example, in the range of 5 µm to 12 µm (5 µm ≤ T₁ ≤ 12 µm).

As shown in FIG. 2(b), the first pattern plating layer 34a is formed on an inner peripheral surface 331 and a top surface 332 of the second panel plating layer 33a. Although not particularly limited, examples of the material constituting the first pattern plating layer 34a may include copper, silver, and gold. Although not particularly limited, the first pattern plating layer 34a in the present embodiment is a copper plating layer formed on the second panel plating layer 33a in the vicinity of the through hole 50 by a pattern plating method (button plating method).

As shown in FIG. 2(a), the first pattern plating layer 34a is concentric with the second panel plating layer 33a, but has an annular shape with a diameter different from that of the second panel plating layer 33a. Specifically, a diameter R₂ of the first pattern plating layer 34a is smaller than a diameter R₁ of the second panel plating layer 33a (R₂ < R₁).

Accordingly, as shown in FIG. 2(b), the first pattern plating layer 34a covers the whole of the inner peripheral surface 331 of the second panel plating layer 33a, but covers only part of the top surface 332 of the second panel plating layer 33a. This generates a level difference 311a between a top surface 342 of the first pattern plating layer 34a and the top surface 332 of the second panel plating layer 33a on a top surface 310 of the land portion 31a.

Although not particularly limited in the present embodiment, a thickness T₃ of the first pattern plating layer 34a is 1/2 or less of the thickness T₁ of the second metal foil layer 32a (T₃ ≤ (1/2) × T₁). Although not particularly limited, the thickness T₃ of the first pattern plating layer 34a may be 1/5 or more of the thickness T₁ of the second metal foil layer 32a (T₃ ≥ (1/5) × T₁). The thickness T₃ of the first pattern plating layer 34a is 1/2 or less of the thickness T₁ of the second metal foil layer 32a, whereby the fine lines of the wiring pattern 20 can be formed with high accuracy. Although not particularly limited, the thickness T₃ of the first pattern plating layer 34a may be, for example, in the range of 2 µm to 5 µm (2 µm ≤ T₃ ≤ 5 µm).

As shown in FIG. 2(b), the land portion 31b has basically the same structure as that of the land portion 31a described above except that it is formed on the bottom surface 12 of the insulating base material 10. The land portion 31b in the present embodiment has an annular shape concentric with the through hole 50, and is formed on the bottom surface 12 so as to surround the through hole 50. More precisely, part of the inside of the land portion 31b is located inside the through hole 50 and also below the through hole 50.

The land portion 31b includes the second metal foil layer 32b, a second panel plating layer 33b, and a first pattern plating layer 34b. The second metal foil layer 32b also corresponds to an example of the "metal foil layer" of the flexible printed wiring board in the aspects of the present invention, the second panel plating layer 33b also corresponds to an example of the "third plating layer" in the aspects of the present invention, and the first pattern plating layer 34b also corresponds to an example of the "fourth plating layer" in the aspects of the present invention.

The second metal foil layer 32b is formed on the bottom surface 12 of the insulating base material 10. Similarly to the second metal foil layer 32a, the second metal foil layer 32b has an annular shape surrounding the through hole 50, and defines a lower part of the through hole 50. Although not particularly limited, examples of the material constituting the second metal foil layer 32a may include copper, silver, and gold. Although not particularly limited, the second metal foil layer 32b in the present embodiment is a copper foil.

Similarly to the second metal foil layer 32a, the second metal foil layer 32b is covered with the second panel plating layer 33b. Similarly to the second panel plating layer 33a, the second panel plating layer 33b has an annular shape following the shape of the second metal foil layer 32b. The second panel plating layer 33b is also formed on the second metal foil layer 32b by the electrolytic panel plating method. Although not particularly limited, examples of the material constituting the second panel plating layer 33b may include the same material as the first panel plating layer 23. However, the material constituting the second panel plating layer 33b may be a material different from that of the first panel plating layer 23.

On the second panel plating layer 33b, the first pattern plating layer 34b having an annular shape with a smaller diameter than that of the second panel plating layer 33b is formed. Although not particularly limited, examples of the material constituting the first pattern plating layer 34b may include the same material as the first pattern plating layer 34a. However, the material constituting the first pattern plating layer 34b may be a material different from that of the first pattern plating layer 34a. Although not particularly limited, the first pattern plating layer 34b in the present embodiment is a copper plating layer formed by the pattern plating method.

Similarly to the land portion 31a described above, the thickness of the second panel plating layer 33b and the thickness of the first pattern plating layer 34b are each 1/2 or less of the thickness of the second metal foil layer 32b also in such a land portion 31b.

The through-hole plating portion 35a has a cylindrical shape along the inner wall of the through hole 50, and is formed on the insulating base material 10 inside the through hole 50. Upper and lower parts of the through-hole plating portion 35a are sandwiched between the land portions 31a and 31b, whereby the land portions 31a and 31b are electrically connected to each other.

The through-hole plating portion 35a includes a third panel plating layer 36a and a second pattern plating layer 37a. The third panel plating layer 36a is formed on the insulating base material 10 inside the through hole 50, and has a cylindrical shape extending along a thickness direction of the insulating base material 10. The third panel plating layer 36a is formed integrally with the second panel plating layers 33a, 33b, and is made of the same material as those of the second panel plating layers 33a, 33b.

The second pattern plating layer 37a is formed on the inward side of the third panel plating layer 36a inside the through hole 50, and has a cylindrical shape extending along the thickness direction of the insulating base material 10. The second pattern plating layer 37a is formed integrally with the first pattern plating layers 34a, 34b, and is made of the same material as those of the first pattern plating layers 34a, 34b.

The flexible printed wiring board 1A according to the present embodiment includes the land portions 31a, 31b including the second panel plating layers 33a, 33b and the first pattern plating layers 34a, 34b respectively having diameters different from each other. With such a configuration, the flexible printed wiring board 1A can be manufactured by the manufacturing method described below, and thus, it is possible to suppress poor formation of the wiring pattern 20 and improve connection reliability.

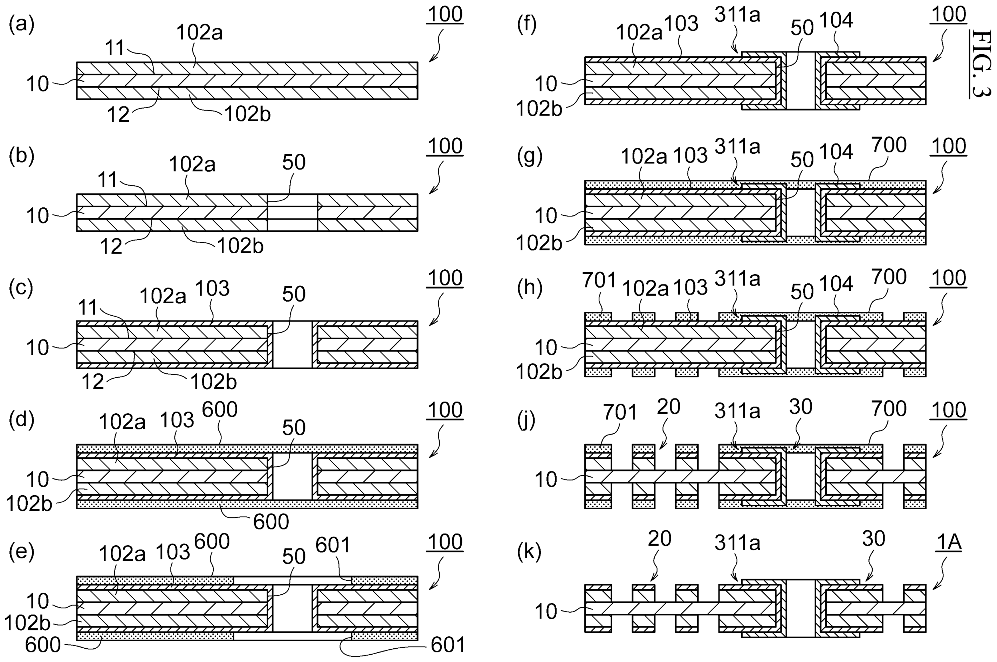

The following describes a method of manufacturing the flexible printed wiring board 1A according to the present embodiment with reference to FIG. 3. FIG. 3(a) to FIG. 3(k) are each a sectional view showing the method of manufacturing the flexible printed wiring board 1A according to the present embodiment.

First, as shown in FIG. 3(a), a double-sided substrate 100 is prepared (preparing step). The double-sided substrate 100 includes the insulating base material 10, and metal foil layers 102a, 102b formed on the top and bottom surfaces 11, 12 of the insulating base material 10, respectively. Although not particularly limited, examples of the double-sided substrate 100 may include a double-sided copper clad laminate. The metal foil layer may be a metal other than copper, and may be silver or gold, for example. Moreover, the double-sided substrate 100 corresponds to an example of the "substrate" in the aspects of the present invention.

Next, as shown in FIG. 3(b), the through hole 50 penetrating the insulating base material 10 and the top and bottom surfaces 11, 12 is formed in the double-sided substrate 100 (hole formation step). Although not particularly limited, the through hole 50 can be formed in the double-sided substrate 100 by a laser, a drill, or the like. Although not particularly limited, desmear treatment or conductive treatment may be performed on the through hole 50. Note that the conductive treatment is a pretreatment process of a panel plating step as a subsequent process, and may be, for example, treatment of adding a conductive material to the inner wall of the through hole 50 by direct plating or the like.

Next, as shown in FIG. 3(c), a first plating layer 103 is formed in the double-sided substrate 100 by the panel plating method (panel plating step). Note that the panel plating method is typically a method of forming a plating layer on the entire surface of a substrate (production panel) and a through hole by electrolytic plating. In the present embodiment, the first plating layer 103 is formed on the whole of the top and bottom surfaces 11, 12 including the periphery of the through hole 50 and inside the through hole 50 by the panel plating method. The panel plating step corresponds to an example of the first plating step in the aspects of the present invention.

In the present embodiment, the thickness of the first plating layer 103 can be 1/2 or less of the thickness of each of the metal foil layers 102a, 102b. Note that the thickness of the first plating layer 103 can be controlled by an electrolytic plating time and current density.

Next, as shown in FIG. 3(d), dry films 600 as plating resists are attached to both sides of the double-sided substrate 100. Although not particularly limited, the dry film 600 is a negative resist film, in which an exposed part hardens and becomes insoluble in a developing solution, while an unexposed part dissolves in the developing solution.

Next, as shown in FIG. 3(e), the dry film 600 is exposed and developed to form a resist pattern 601. The resist pattern 601 is a pattern for forming the first and second pattern plating layers 34a, 34b of the flexible printed wiring board 1A described above, and its contour corresponds to the contour of each of the first and second pattern plating layers 34a, 34b.

Next, as shown in FIG. 3(f), a second plating layer 104 is formed around the through hole 50 and inside the through hole 50 by the pattern plating method, and the dry film 600 is peeled off. In the present embodiment, the second plating layer 104 can be formed on the first plating layer 103 around and inside the through hole 50 by forming the second plating layer 104 only inside the resist pattern 601 by the pattern plating method. This forms the level difference 311a described above. In addition, the dry film 600 can be peeled off with a common peeling liquid or the like. Note that a series of steps shown in FIGS. 3(d) to 3(f) corresponds to an example of the "second plating step" in the aspects of the present invention.

In the present embodiment, the thickness of the second plating layer 104 can be 1/2 or less of the thickness of each of the metal foil layers 102a, 102b. The thickness of the second plating layer 104 can be controlled by an electrolytic plating time and current density.

Next, as shown in FIG. 3(g), dry films 700 as etching resists are attached to both sides of the double-sided substrate 100. The first and second plating layers 103, 104 are covered with the dry film 700. Although not particularly limited, the same one as the dry film 600 described above can be used for the dry film 700, for example.

Next, as shown in FIG. 3(h), the dry film 700 is exposed and developed to form a resist pattern 701.

Next, as shown in FIG. 3(j), the metal foil layers 102a, 102b, the first plating layer 103, and the second plating layer 104 are etched to form the wiring pattern 20 and the land portions 31a, 31b.

Next, as shown in FIG. 3(k), the dry film 700 is peeled off. The dry film 700 can be peeled off with a common peeling liquid or the like. Note that a series of steps shown in FIGS. 3(g) to 3(j) corresponds to an example of the "patterning step" in the aspects of the present invention.

As described above, it is possible to manufacture the flexible printed wiring board 1A according to the present embodiment. According to such a manufacturing method, the plating step includes a first plating step and a second plating step. This can gradually make the plating layer thinner toward the outside of the through hole in the land portions 31a, 31b, thereby reducing the level difference 311a. At the same time, the plating layer having a sufficient thickness can be formed in the land portions 31a, 31b. As described above, it is possible to suppress poor formation of the wiring pattern 20 and improve connection reliability in the land portions 31a, 31b.

In the present embodiment, plating is performed such that the thickness of the first plating layer 103 and the thickness of the second plating layer 104 are 1/2 or less of the thickness of each of the metal foil layers 102a, 102b. As described above, by reducing the thickness of the plating layer, a fine pattern can be formed with high accuracy at the etching step (see FIG. 3(j)).

### [Second Embodiment]

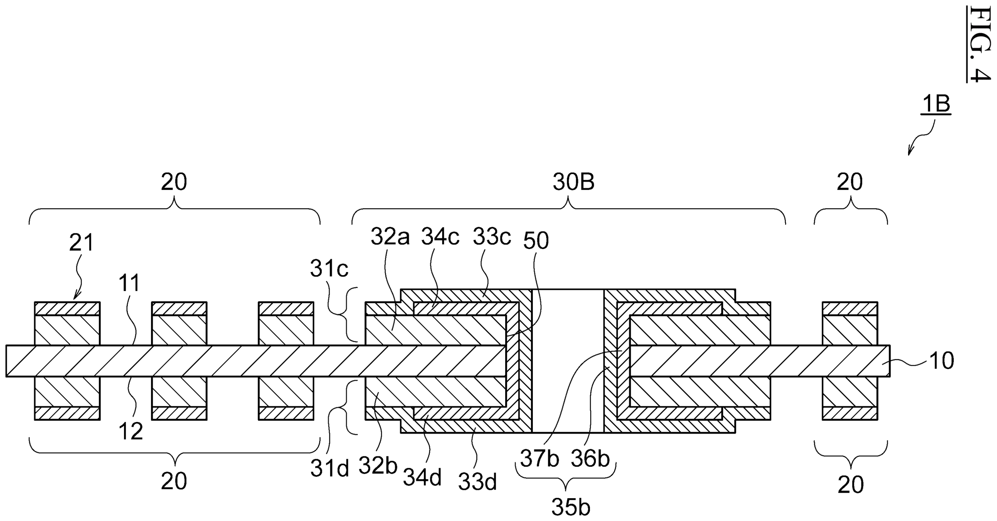

FIG. 4 is a sectional view showing a flexible printed wiring board 1B according to a second embodiment of the present invention. As shown in FIG. 4, in comparison to the flexible printed wiring board 1A according to the first embodiment, the flexible printed wiring board 1B according to the second embodiment differs from the flexible printed wiring board 1A according to the first embodiment in that a panel plating layer is formed on a pattern plating layer in an interlayer connection portion 30B. However, the other configurations are the same as those in the first embodiment. The following describes only differences of the flexible printed wiring board 1B according to the second embodiment from the flexible printed wiring board 1A according to the first embodiment, and the same components as those in the first embodiment are denoted by the same reference numerals to omit the description thereof.

The interlayer connection portion 30B in the second embodiment includes land portions 31c, 31d and a through-hole plating portion 35b.

In the land portions 31c, 31d in the second embodiment, first pattern plating layers 34c, 34d are formed on the second metal foil layers 32a, 32b, respectively. Then, second panel plating layers 33c, 33d are further formed on the second metal foil layers 32a, 32b and the first pattern plating layers 34c, 34d. The first pattern plating layers 34c, 34d correspond to an example of the "third plating layer" in the aspects of the present invention, and the second panel plating layers 33c, 33d correspond to an example of the "fourth plating layer" in the aspects of the present invention.

Also in the second embodiment, level differences 311b are formed in the land portions 31c, 31d. The level differences 311b are formed by the second panel plating layers 33c, 33d being bent in the thickness direction of the insulating base material 10 along the shapes of outer peripheral edges of the first pattern plating layers 34c, 34d.

In the through-hole plating portion 35b in the second embodiment, a second pattern plating layer 37b is formed on the insulating base material 10, and a third panel plating layer 36b is formed on the second pattern plating layer 37b.

Also in the flexible printed wiring board 1B as described above, similarly to the flexible printed wiring board 1A according to the first embodiment, the plating layer can be gradually made thinner toward the outside of the through hole 50 in the land portions 31c, 31d, thereby reducing the level difference 311b. At the same time, the plating layer having a sufficient thickness can be formed in the land portions 31c, 31d. As described above, it is possible to suppress poor formation of the wiring pattern 20 and improve connection reliability in the land portions 31c, 31d.

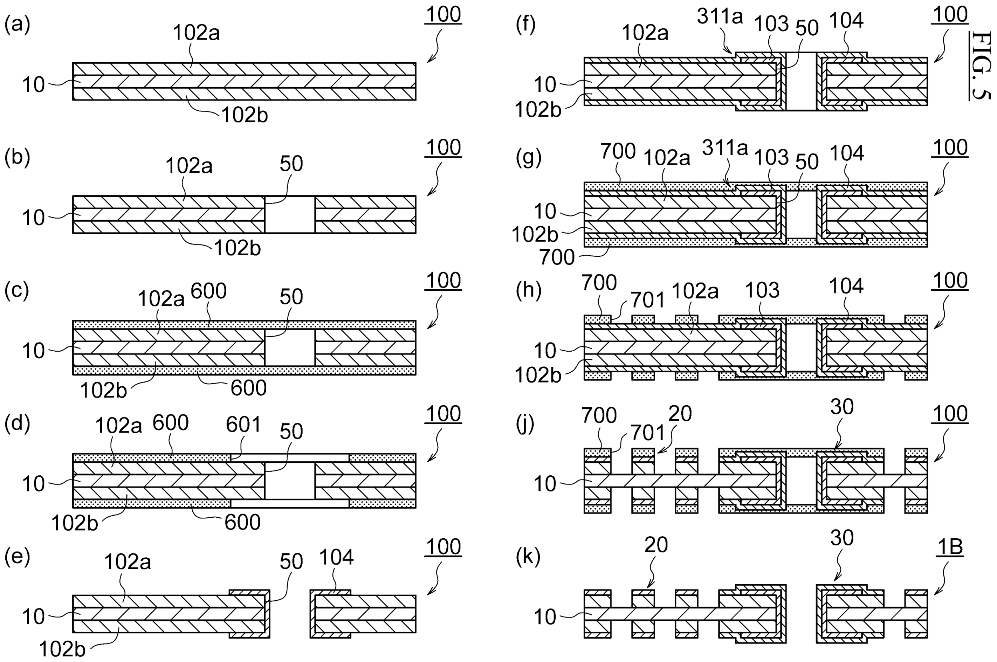

The following describes a method of manufacturing the flexible printed wiring board 1B according to the second embodiment with reference to FIG. 5. However, a detailed description of the contents common to the method of manufacturing the flexible printed wiring board 1A according to the second embodiment will be omitted.

FIG. 5(a) to FIG. 5(k) are each a sectional view showing the method of manufacturing the flexible printed wiring board 1B according to the present embodiment. First, as shown in FIG. 5(a), the double-sided substrate 100 is prepared (preparing step), similarly to the first embodiment.

Next, as shown in FIG. 5(b), the through hole 50 penetrating the insulating base material 10 and the top and bottom surfaces 11, 12 is formed in the double-sided substrate 100 (hole formation step), similarly to the first embodiment.

Next, as shown in FIG. 5(c), the dry films 600 as plating resists are attached to both sides of the double-sided substrate 100. Accordingly, the entire surface of the metal foil layers 102a, 102b and the through hole 50 are covered with the dry films 600.

Next, as shown in FIG. 5(d), the dry film 600 is exposed and developed to form a resist pattern 601. The resist pattern 601 is a pattern for forming the first and second pattern plating layers 34c, 34d of the flexible printed wiring board 1B described above, and its contour corresponds to the contour of each of the first and second pattern plating layers 34c, 34d.

Next, as shown in FIG. 5(e), the second plating layer 104 is formed around the through hole 50 and inside the through hole 50 by the pattern plating method, and the dry film 600 is peeled off. The second plating layer 104 corresponds to the first to third pattern plating layers 34c, 34d, 36b described above. A series of steps shown in FIGS. 5(c) to 5(e) corresponds to an example of the "second plating step" in the aspects of the present invention.

Next, as shown in FIG. 5(f), the first plating layer 103 is formed on the double-sided substrate 100 by the panel plating method. In the second embodiment, the first plating layer 103 is formed also on the second plating layer 104 around and inside the through hole 50, in addition to on the metal foil layers 102a, 102b. The step shown in FIG. 5(f) corresponds to an example of the "first plating step" in the aspects of the present invention.

Next, as shown in FIG. 5(g), the dry films 700 as etching resists are attached to both sides of the double-sided substrate 100.

Next, as shown in FIG. 5(h), the dry film 700 is exposed and developed to form a resist pattern 701.

Next, as shown in FIG. 5(j), the metal foil layers 102a, 102b, the second plating layer 104, and the first plating layer 103 are etched to form the wiring pattern 20 and the land portions 31c, 31d.

Next, as shown in FIG. 5(k), the dry film 700 is peeled off. As described above, it is possible to manufacture the flexible printed wiring board 1B according to the present embodiment.

Also in the method of manufacturing the flexible printed wiring board 1B as described above, the level difference 311b can be made smaller, and the plating layer having a sufficient thickness can be formed in the land portions 31c, 31d. Therefore, it is possible to suppress poor formation of the wiring pattern 20 and improve connection reliability in the land portions 31c, 31d.

The embodiments described above are described to easily understand the present invention, and are not provided to limit the present invention. Therefore, each component disclosed in the embodiments described above is intended to also include all design changes or equivalents belonging to the technical scope of the present invention.

For example, in the first and second embodiments described above, the through hole 50 is formed in the flexible printed wiring boards 1A, 1B, but the present invention is not limited to this. A bottomed hole may be formed instead of the through hole 50. In this case, the land portion is formed only on one side of the flexible printed wiring boards 1A, 1B.

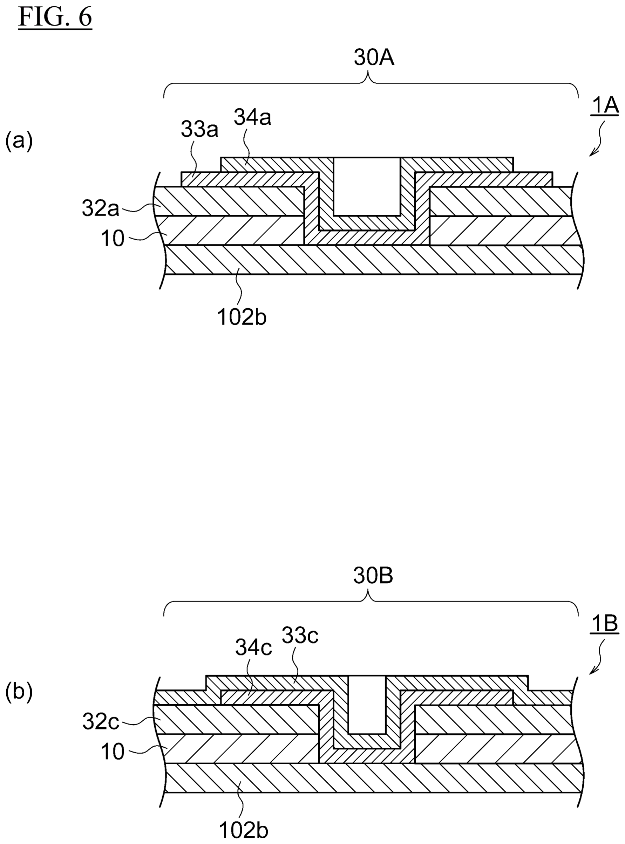

FIG. 6(a) is a sectional view showing a modification of the interlayer connection portion 30A of the flexible printed wiring board 1A according to the first embodiment, and FIG. 6(b) is a sectional view showing a modification of the interlayer connection portion 30B of the flexible printed wiring board according to the second embodiment.

As shown in FIG. 6(a), a bottomed hole 55 in the modification of the first embodiment penetrates the insulating base material 10 and the second metal foil layer 32b. Then, the bottom of the bottomed hole 55 is closed by the metal foil layer 102b. In the modification, the second panel plating layer 33a and the first pattern plating layer 34a are formed also at the bottom of the bottomed hole 55. The second panel plating layer 33a and the first pattern plating layer 34a as described above can be formed by basically the same procedure as the first and second plating steps described in FIG. 3.

As shown in FIG. 6(b), the bottom of the bottomed hole 55 in the modification of the second embodiment is also closed by the metal foil layer 102b. In the modification, the first pattern plating layer 34c and the second panel plating layer 33c are formed also at the bottom of the bottomed hole 55. The first pattern plating layer 34c and the second panel plating layer 33c as described above can be formed by basically the same procedure as the first and second plating steps described in FIG. 5.

### Description of Reference Numerals

- 1A, 1B: Flexible printed wiring board
- 10: Insulating base material
- 11: Top surface
- 12: Bottom surface
- 20: Wiring pattern
- 21: Fine line
- 22: First metal foil layer
- 23: First panel plating layer
- 30A, 30B: Interlayer connection portion
- 31a to 31d: Land portion
- 310: Top surface
- 311a, 311b: Level difference
- 32a, 32b: Second metal foil layer
- 321: Inner peripheral surface
- 322: Top surface
- 33a to 33d: Second panel plating layer
- 331: Inner peripheral surface
- 332: Top surface
- 34a to 34d: First pattern plating layer
- 332: Top surface
- 35a, 35b: Through-hole plating portion
- 36a, 36b: Third panel plating layer
- 37a, 37b: Second pattern plating layer
- 50: Through hole
- 55: Bottomed hole
- 100: Double-sided substrate
- 102a, 102b: Metal foil layer
- 103: First plating layer
- 104: Second plating layer
- 600, 700: Dry film
- 601, 701: Resist pattern

## Claims

1. A method of manufacturing a flexible printed wiring board, comprising:
a preparing step of preparing a substrate having an insulating layer and a metal foil layer laminated on the insulating layer;
a hole formation step of forming a hole in the insulating layer and the metal foil layer; and
a plating step of forming a plating layer around and inside the hole, wherein
the plating step includes:
a first plating step of forming a first plating layer around and inside the hole by a panel plating method; and
a second plating step of forming a second plating layer around and inside the hole by a pattern plating method.

2. The method of manufacturing the flexible printed wiring board according to claim 1, wherein
the first plating step includes forming the first plating layer such that the first plating layer has a thickness of 1/2 or less of a thickness of the metal foil layer, and
the second plating step includes forming the second plating layer such that the second plating layer has a thickness of 1/2 or less of the thickness of the metal foil layer.

3. The method of manufacturing the flexible printed wiring board according to claim 1 or 2, wherein
the second plating step is performed after the first plating step and includes forming the second plating layer on the first plating layer.

4. The method of manufacturing the flexible printed wiring board according to claim 1 or 2, wherein
the first plating step is performed after the second plating step and includes forming the first plating layer on the second plating layer.

5. The method of manufacturing the flexible printed wiring board according to any one of claims 1 to 4, further comprising
a patterning step of etching the second plating layer, the first plating layer, and the metal foil layer to form a wiring pattern and a land portion surrounding the hole, wherein
in the land portion, a diameter of the second plating layer is smaller than a diameter of the first plating layer.

6. A flexible printed wiring board comprising:
an insulating layer; and
a land portion laminated on the insulating layer, wherein
the land portion includes:
a metal foil layer;
a third plating layer laminated on the metal foil layer; and
a fourth plating layer laminated on the third plating layer,
the flexible printed wiring board has a hole formed in the insulating layer and the metal foil layer and surrounded by the land portion,
the third and fourth plating layers are formed around and inside the hole, and
in the land portion, a diameter of the third plating layer is different from a diameter of the fourth plating layer.

7. The flexible printed wiring board according to claim 6, wherein
a thickness of the third plating layer is 1/2 or less than a thickness of the metal foil layer, and
a thickness of the fourth plating layer is 1/2 or less than the thickness of the metal foil layer.
